**Europäisches Patentamt**

**European Patent Office**

**Office européen des brevets**

(19)

(11) Veröffentlichungsnummer : **0 384 330 B1**

(12)

# EUROPÄISCHE PATENTSCHRIFT

(45) Veröffentlichungstag der Patentschrift :
**13.05.92 Patentblatt 92/20**

(51) Int. Cl.⁵ : **G01D 5/20, H03M 1/68**

(21) Anmeldenummer : **90103094.0**

(22) Anmeldetag : **17.02.90**

(54) **Messverfahren zur Wegmessung mittels Resolver und Inductosyn.**

(30) Priorität : **22.02.89 DE 3905382**

(43) Veröffentlichungstag der Anmeldung :
**29.08.90 Patentblatt 90/35**

(45) Bekanntmachung des Hinweises auf die
Patenterteilung :
**13.05.92 Patentblatt 92/20**

(84) Benannte Vertragsstaaten :
**AT BE CH DE ES FR GB GR IT LI LU NL SE**

(56) Entgegenhaltungen :
**US-A- 3 789 393**
**WERKSTATT UND BETRIEB. vol. 108, no. 8,**
**August 1975, MUNCHEN DE Seiten 507 - 513;**
**A. Signer: "Verfahren zur Wegmessung mitIn-**
**ductosyn"**

(73) Patentinhaber : **GROSSENBACHER**
**ELEKTRONIK AG**
**Elestastrasse**
**CH-7310 Bad Ragaz (CH)**

(72) Erfinder : **Dajcar, Richard, Dipl.-Ing.**
**Kirchgasse 5**
**CH-7310 Bad Ragaz (CH)**

(74) Vertreter : **Riebling, Peter, Dr.-Ing.,**
**Patentanwalt**
**Rennerle 10, Postfach 31 60**
**W-8990 Lindau/B. (DE)**

## Beschreibung

Die Erfindung betrifft ein Meßverfahren zur Wegmessung mittels Resolver und Inductosyn bzw. Winkelmessung oder kontinuierliche Positionserfassung, wobei in Anwendung der Fourier-Analyse periodische Rechtecksignale U1, U2 den Eingangspulen einer Mepßeinrichtung zugeführt werden und am Ausgang der Meßeinrichtung durch Induktion in einer weiteren Spule ein Ausgangssignal U3 erzeugt wird, und die Rechtecksignale U1, U2 am Eingang der Meßeinrichtung in der Impulsbreite einem Digitalwert $\beta$ folgen, wobei die Impulsbreiten der Rechtecksignale U1 bzw. U2 entsprechend einer Grobauflösung schrittweise mit dem Digitalwert $\beta$ verbreitert bzw. verkleinert werden und das Ausgangssignal U3 abhängig vom Wert $\alpha$ entsprechend der mechanischen Position und abhängig vom Digitalwert $\beta$ durch Nachführen von Zählern, die dem Digitalwert $\beta$ entsprechen, auf Null abgeglichen wird und dann der bekannte Digitalwert $\beta$ der zu ermittelnden mechanischen Position $\alpha$ entspricht.

Das hier vorliegende Meßverfahren bezieht sich auf eine zyklisch absolute Erfassung mittels einem Resolver bzw. Inductosyn, der aus einem Stator bzw. Slider und aus einem Rotor bzw. Scale besteht, die in Verbindung mit daran angeordneten Spulen, an denen Rechteckspannungen anliegen bzw. eine Ausgangsspannung abgenommen wird, gegeneinander verschoben werden. Das Meßverfahren der vorliegenden Erfindung bezieht sich auch auf Messungen, wo mittels optischer Methoden das Ausgangssignal erzeugt wird.

Die Meßeinrichtung des eingangs genannten Meßverfahrens betreffend Inductosyn ist bereits aus der DE-AS 23 49 904 bekannt.

In kurzer Erläuterung wird zunächst der Unterschied des gattungsbildenden Meßverfahrens gegenüber der Erfindung erläutert.

Bei dem Meßverfahren nach der DE-AS werden im wesentlichen in Impulsmitte der Rechtecksteuersignale Feinimpulse der Amplitude nach aufaddiert bzw. gem. Skizze B von der Impulsmitte abgezogen in Verbindung mit einer Impulsverbreiterung gem. dem nächstfolgenden Grobschritt.

Bei der Erfindung jedoch wird eine Amplitudenaddition beidseitig an den Flanken des Rechtecksteuersignals vorgenommen, solange bis der nächste Grobschritt erreicht wird.

Mit der Aufaddierung bzw. Subtraktion von Feinimpulsen in Impulsmitte der Rechtecksteuersignale nach dem Stand der Technik ergeben sich, wie später noch erläutert wird, erhebliche Nachteile. So muß ein erheblich größerer Schaltungsaufwand getrieben werden und außerdem arbeitet das Verfahren wegen der Addition bzw. Subtraktion von Impulsen aus einer Quelle auf Impulse einer anderen Quelle, insbesondere hinsichtlich einer Temperaturdrift nicht besonders betriebssicher.

Aufgabe der vorliegenden Erfindung ist es deshalb, das Meßverfahren der genannten Art so weiterzubilden, daß bei wesentlich geringerem Schaltungsaufwand eine höhere Betriebssicherheit erreicht wird.

Zur Lösung der gestellten Aufgabe ist die Erfindung dadurch gekennzeichnet, daß die Feinauflösung schrittweise linear und stetig durch Änderung der Amplitude A1 - A9 an den beiden Seiten der Rechtecksteuersignale U1, U2 im Bereich der jeweiligen Impulsbreite durchgeführt wird.

Das Wesen der Erfindung liegt demnach darin, daß an den Flanken der Rechtecksteuerimpulse Feinamplituden in Form einer Feinauflösung aufgebaut werden, wobei dieser Aufbau schrittweise linear und stetig erfolgt, bis die Amplitude völlig aufgebaut bzw. abgebaut ist und dann der nächste Grobscrhitt erreicht wird. Bei der Erfindung wird demnach nur eine Quelle bzw. ein Spannungssignal, hier der Rechteckimpuls U1 oder U2 schrittweise an den Flanken verändert, wobei hier für diese wie beim Stand der Technik vorgesehen ist, eine Anhäufung von unterschiedlichen Signalquellen vermieden wird, wobei diese Signalquellen beim Stand der Technik miteinander vermischt werden müssen. Dadurch, daß bei der Erfindung der Ausgang nur von einer einzigen Quelle genommen wird, ergibt sich ein wesentlich niedriger Schaltungsaufwand bei höherer Betriebssicherheit.

Ausgehend von der DE-AS 23 49 904 ist nicht ersichtlich, wie dort bei höherer Betriebssicherheit eine Vereinfachung der Schaltung erreicht werden könnte. In überraschender Weise kann bei der Erfindung mit der Änderung der Flanken nur einer einzigen Spannungsquelle ein erheblicher Schaltungsaufwand eingespart werden, wodurch sich auch, insbesondere in Hinsicht auf eine Temperaturdrift eine wesentlich höhere Betriebssicherheit ergibt.

Die an sich bekannte Grobauflösung wird nach Art von inkrementalen Schritten in der Änderung der Impulsbreite der Rechteckimpulse also nach wie vor beibehalten. Innerhalb der einzelnen Schritte der Grobauflösung wird jedoch noch eine Feinauflösung zusätzlich vorgenommen , und zwar durch schrittweisen Aufbau bzw. Abbau der Amplituden der Rechtecksteuersignale , bis der nächste Schritt der Grobauflösung erreicht ist.

Der wesentliche Vorteil des erfindungsgemässen Meßverfahrens liegt darin, daß man nun mit der gleichen Meßfrequenz arbeiten kann wie beim bekannten Stand der Technik, d.h. mit einer Meßfrequenz von etwa 8 kHz, die besonders vorteilhaft in Verbindung mit digitalen Schaltungen angewendet werden kann, daß man nun aber in Verwendung der Erfindung eine zum Beispiel um zehnfach gesteigerte Auflösung erhält.

2

Bei den bekannten Meßverfahren kann die Steigerung der Auflösung nur erreicht werden, wenn dabei unerwünscht hohe Frequenzen in Kauf genommen werden, die bei der späteren Auswertung in der Elektronik zu Problemen Anlaß geben könnten.

Auf der anderen Seite kann zwar möglicherweise eine hohe Auflösung erreicht werden, wobei man dann jedoch eine geringe Verfahrgeschwindigkeit der Meßeinrichtung in Kauf nehmen muß.

Bei der vorliegenden Erfindung ist erreicht, daß bei einer hohen Verfahrgeschwindigkeit der Meßeinrichtung, wie ansich bekannt, eine überlegene Auflösung der Meßeinrichtung erzielt werden kann. In umgekehrter Weise wird mit der Erfindung ebenfalls erreicht, daß bei gleicher Auflösung der Meßeinrichtung, wie bislang bekannt, die Verfahrgeschwindigkeit um ein wesentliches Maß gesteigert werden kann.

Mit der vorliegenden Erfindung ergibt sich demnach der Vorteil, daß kleinere Inkrementalschritte in Verbindung mit dem erfindungsgemässen Meßverfahren möglich sind, so daß beispielsweise bei gleicher Verfahrgeschwindigkeit der Meßeinrichtung 10 x kleinere Inkrementalschritte auswertbar sind, als es bisher bekannt ist.

In bevorzugter Ausgestaltung ist es vorgesehen, daß die Amplitudenänderung für die Feinauflösung in aufeinanderfolgenden gleichen Schritten erfolgt.

In einer anderen Anwendung ist es vorgesehen, daß die Amplitudenänderung für die Feinauflösung in sich stetig ändernden Schritten erfolgt.

Hierbei werden vorteilhaft die Grundwellen aus den Rechtecksteuersignalen vor der Meßeinrichtung ausgefiltert.

In vorteilhafter Anordnung werden weiterhin die Rechtecksteuersignale direkt auf die Meßeinrichtung geführt und die Grundwelle wird aus dem Ausgangssignal der Meßeinrichtung ausgefiltert.

In einer Ausgestaltung ist es vorteilhaft vorgesehen, daß die Änderung der Impulsbreite und/oder der Amplitude gleichzeitig oder abwechslungsweise in den beiden Steuersignaien U1 und U2 erfolgen.

Die Steuerlogik der Meßeinrichtung wird sowohl aus einer ansich bekannten Stufe für die Grobauflösung betreffend die Impulsbreite als auch aus einer zusätzlichen Stufe für die Amplitude betreffend die Feinauflösung aufgebaut.

Das Ausgangssignal U3 der Meßeinrichtung wird zunächst einer Austaststufe zugeführt zur Erzeugung von Impulsen betreffend die Zählrichtung der Meßeinrichtung und zur Erzeugung von Wegimpulsen.

In vorteilhafter Ausgestaltung werden von der Zählrichtung und den Wegimpulsen über eine zusätzliche Auswerteschaltung zwei um 90° elektrisch verschobene Signale erzeugt zur inkrementalen Ausgabe des zurückgelegten Weges zur externen Positionserfassung.

Vorteilhaft ist ausgehend von der Zählrichtung und den Wegimpulsen eine weitere Auswerteschaltung vorgesehen zur Ausgabe des Absolutwertes der Position nach Art einer internen Positionserfassung.

Vorteilhaft werden die Impulse betreffend die Zählrichtung und die Wegimpulse einem Zähler zugeführt, der an seinem Ausgang entsprechend den Schritten der Feinauflösung Ausgangsleitungen, z.B. 0 bis 9, aufweist, die im weiteren der Decodierstufe betreffend die Decodierung der Amplitude der Rechtecksteuersignale U1, U2 zugeführt werden.

In vorteilhafter Weise stehen die Decodierstufen mit digitalen Verstärkern in Verbindung, welche schrittweise entsprechend den Schritten der Feinauflösung über Strom- oder Spannungsquellen die Amplituden der Rechtecksteuersignale U1, U2 schalten.

Die Rechtecksteuersignale U1, U2 am Ausgang von digitalen Verstärkern werden vorteilhaft über Umschalter in der Polarität oder Stromrichtung umgeschaltet, wobei eine Steuerleitung ausgehend von den Decodierstufen mit den Umschaltern in Verbindung steht.

In vorteilhafter Ausgestaltung steht die Ansteuerlogik mit dem Oszillator über eine Leitung mit der Zählrichtung des Ausgangssignals sowie über eine weitere Leitung mit dem Übertrag, ausgehend von dem Zähler betreffend die Feinauflösung in Verbindung, wobei über Ausgänge mittels umlaufender Zähler und ansich bekannter Decodierstufen in der Impulsbreite variable Signale betreffend einzelne Schritte der Grobauflösung gebildet werden.

Das Meßverfahren wird vorteilhaft in Meßeinrichtungen auf induktiver Basis z.B. Resolver und Inductosyn eingesetzt.

In einer Ausgestaltung kann das Meßverfahren auch vorteilhaft in optischen Meßeinrichtungen eingesetzt werden.

In vorteilhafter Weise wird im Zustand 0 der Grob- und Feinauflösung eine Nullmarke ausgegeben.

In einer Ausgestaltung ist es vorgesehen, daß der IST-Wert innerhalb des Meßbereichs als Absolutwert oder Inkremental ausgegeben wird.

Im folgenden wird die Erfindung anhand von mehreren Ausführungswege darstellenden Zeichnungen näher erläutert. Hierbei gehen aus den Zeichnungen und ihrer Beschreibung weitere Merkmale und Vorteile der Erfindung hervor.

Es zeigen:

Figur 1 die Meßeinrichtung mit Scale (Rotor) und Slider (Stator) mit den mäanderförmig aufgebrachten Spulen in schematischer Darstellung,

Figur 2 ein Blockschaltbild mit der Meßeinrichtung mit den Eingangs- und Ausgangssignalen,

Figur 3 und Figur 3a die Rechtecksignale U1B, U2B am Eingang der Meßeinrichtung,

Figur 4 und Figur 4a die Rechtecksignale U1B und U2B am Eingang der Schaltung mit einer Amplitudenveränderung entsprechend einem Schritt der Feinauflösung,

Figur 5 und Figur 5a die Rechtecksignale U1B und U2B am Eingang der Meßeinrichtung mit einer Amplitudenveränderung nach neun Schritten der Feinauflösung,

Figur 6 und Figur 6a die Rechtecksignale U1B und U2B am Eingang der Meßeinrichtung mit Darstellung des erreichten Grobschrittes nach dem Vollziehen der einzelnen Schritte der Feinauflösung,

Figur 7 ein Blockschaltbild der Steuerelektronik zum Aufschalten auf die Meßeinrichtung nach Figur 2,

Figur 8 ein verfeinertes Blockschaltbild der Steuerelektronik,

Figur 9 die Anordnung der geschalteten Strom- oder Spannungsquellen für die Erzeugung der Amplitude der Rechtecksteuersignale U1B und U2B gemäss der Grob- und Feinauflösung,

Figur 10 ein weiteres Beispiel der geschalteten Strom- oder Spannungsquellen zur Erzeugung der Amplitude der Rechtecksteuersignale.

Bei Meßverfahren (Wegmessung, Winkelmessung, kontinuierliche Positionserfassung) werden sinusförmige Steuersignale U1, U2 als Strom- oder Spannungssignale erzeugt, deren Amplituden abhängig vom Sinus bzw. Cosinus eines digitalen Wertes sind.

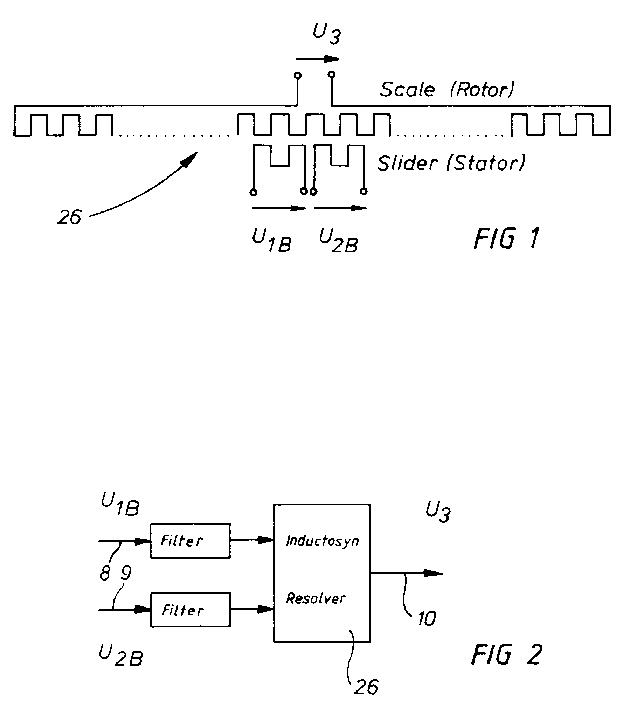

Nach Figur 1 ist ersichtlich, daß dort die Leiterbahnen von Maßstab und Abtastplatte bzw. von Scale und Slider induktiv gekoppelt sind. Am Eingang der Meßeinrichtung 26 liegen hierbei sinusförmige Steuersignale U1 und U2, wodurch am Ausgang über induktive Kopplung das Ausgangssignal U3 erzeugt wird. Die Signalauswertung kann nach der sogenannten Amplitudenmethode oder der Phasenmethode erfolgen.

Aus der im Maßstab induzierten Spannung U3 wird in der Auswerte-Elektronik ein dem Verschiebeweg entsprechendes digitales Signal erzeugt.

Nach Figur 1 werden sinusförmige Steuersignale auf die Meßeinrichtung 26 geführt gemäss:

1. $U1 = U \cdot \sin \beta \cdot \sin\omega t$

2. $U2 = U \cdot \cos \beta \cdot \sin\omega t$

Das Ausgangssignal U3 der Meßeinrichtung ist abhängig von den Steuersignalen U1, U2 bzw. U1B und U2B bei Erzeugung der periodischen Rechtecksignale in Anwendung der Fourier-Analyse und der Lage, Stellung oder dem Zustand der Meßeinrichtung:

3. $U3 = q \cdot U \cdot \sin (\beta-\alpha) \cdot \sin\omega t$

Der Istwert der Meßeinrichtung ist $\alpha$ . Aus 3. wird ersichtlich, daß das Ausgangssignal = 0 ist, wenn $\alpha = \beta$ wird, d.h., wenn der Digitalwert $\beta$ dem Istwert $\alpha$ entspricht. $\alpha$ ist hierbei die mechanische Referenzfunktion, d.h. die mechanische Verschiebung der beiden verschiebbaren Teile zueinander, während $\beta$ die elektrische Position darstellt, die sich in den Impulsbreiten der Steuersignale zeigt.

In der Steuerelektronik des Meßverfahrens wird der Digitalwert $\beta$ so weit nachkorrigiert, bis das Ausgangssignal = 0 ist. Der Digitalwert $\beta$ entspricht dann dem Istwert der Meßeinrichtung. Die Realisierung der oben angegebenen Steuersignale mit hoher Genauigkeit in analoger Schaltungstechnik ist aufwendig und lässt nur eine unzureichende Auflösung der Meßeinrichtung zu.

Ein Verfahren, wo in Anwendung der Fourier-Analyse nach Art von Grobschritten in der Impulsbreite variable Signale verwendet werden, ist unter dem Namen DSCG bekannt, wo die Steuersignale U1B, U2B als Rechtecksignale erzeugt werden.

Hierbei gibt es verschiedene Methoden A und B, wo die Grundwelle der Rechtecksteuersignale nach Fourier den Gleichungen 1. und 2. entsprechen, wobei bei der hier beschriebenen Methode B alle Harmonischen gerader Ordnung fehlen und die Amplitude um den Faktor 2 größer ist als bei Methode A. Die beschriebenen erzeugten periodischen Rechtecksignale werden in der Impulsbreite variiert, wobei die Impulsbreiten der Rechtecksignale einem Digitalwert $\beta$ folgen.

In ansich bekannter Weise lassen sich die gewünschten sinusförmigen Steuersignale mit geeigneten Filtern als Grundwelle nach Figur 2 nach den Rechtecksteuersignalen gewinnen, wobei an Leitungen 8 und 9 von Filtern die Rechtecksteuersignale anliegen und gemäss dem Ausgangssignal U3 an der Leitung 10 weiterverarbeitet werden.

Es ist auch möglich, die Rechtecksteuersignale mit ihrem ganzen Frequenzspektrum direkt auf die Meßeinrichtung 26 zu schalten. Das Ausgangssignal der Meßeinrichtung 26 ist abhängig von den Steuersignaien und der Lage, Stellung oder dem Zustand der Meßeinrichtung und enthält nun das von der Meßeinrichtung 26 beeinflusste Frequenzspektrum. Durch Ausfiltern der Grundwelle nach der Meßeinrichtung 26 kann derart auch das ursprüngliche Ausgangssignal U3 erzeugt werden.

Die Frequenz der Rechtecksteuersignale ist normalerweise fest. Die Impulsbreiten folgen dem Digitalwert β und zwar in Schritten der gewählten Auflösung des Digitalwertes , was einer ansich bekannten Grobauflösung entspricht.

Abhängig von der Frequenz der Rechtecksteuersignale, z.B. 8 KHz und der gewählten Auflösung des Digitalwertes β, z.B. 2000 , folgt eine sehr kleine, zeitliche Verschiebung der Flanken der Rechtecksteuersignale nach Art einer Impulsbreiten-Modulation in einzelnen Schritten, was allerdings keine hohe Auflösung zulässt und lediglich ansich bekannte Grobschritte darstellt.

Soll eine höhere Auflösung, etwa nach Art einer zusätzlichen Feinauflösung erreicht werden, z.B. um den Faktor 10, so liegt nachteilig die zeitliche Verschiebung der Flanken der Rechtecksteuersignale in der Größenordnung der Laufzeiten der digitalen Schaltungen, wodurch schaltungstechnische Probleme entstehen können.

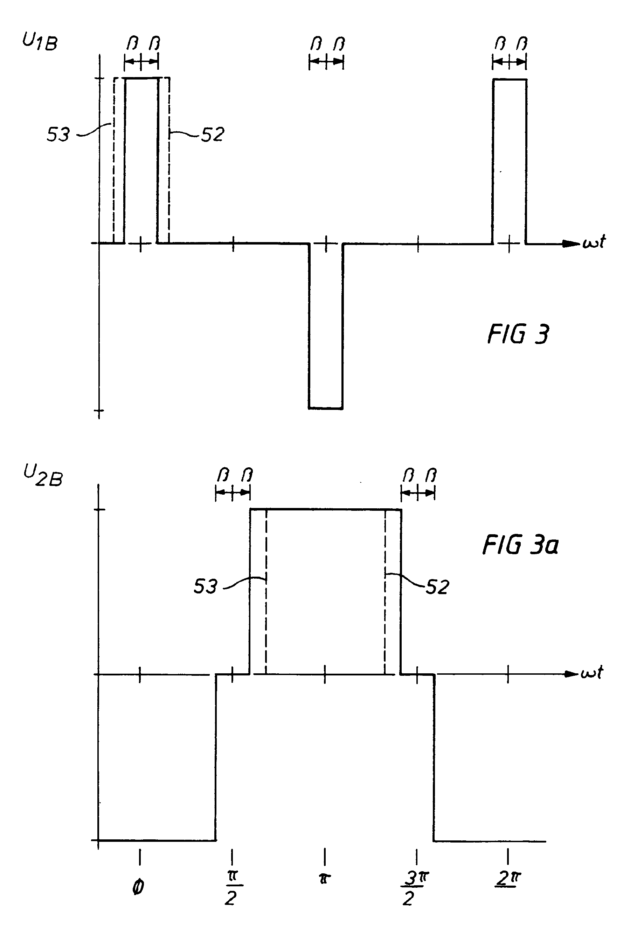

In den Figuren 3 und 3a sind Rechtecksteuersignale U1B und U2B am Eingang der Meßeinrichtung 26 nach den Figuren 1 und 2 dargestellt, wobei der obere Kurvenverlauf nach Figur 3 für den einen Kanal und der untere Kurvenverlauf nach Figur 3a für den anderen Kanal gültig ist.

Es handelt sich hierbeinach Fourier um Signale der Sinus- bzw. Cosinusfunktion, wobei bei der Änderung des einen Signals sich das andere Signal in entgegengesetzter Weise ändert.

In ansich bekannter Weise werden die rechteckförmigen Impulse in der Impulsbreite verändert gemäss einer ansich bekannten Grobauflösung, d.h. gemäss der gestrichelten Darstellung in den Figuren 3 und 3a werden die Rechtecksteuersignale gemäss den Flanken 52, 53 verbreitert bzw. verkleinert nach Art einer Impulsbreiten-Modulation.

Demnach entsprechen die in den Figuren 3 und 3a dargestellten Signale einer konkreten Position der verschiebbar zueinander angeordneten Teile nach Figur 1 entsprechend einem Zustand β = 10, wobei sich die resultierende Spannung U3 zu 0 ergibt, d.h. es wird eine Abstimmung gemäss β = α vorgenommen.

α ist hierbei die mechanische Referenzfunktion, d.h. die mechanische Verschiebung der beiden verschiebbaren Teile zueinander, während β die elektrische Position darstellt, die sich in den Impulsbreiten entsprechend der gestrichelten Darstellung in den Figuren 3 und 3a zeigt.

In der nachgeschalteten Elektronik wird nach Art einer Nachlaufsteuerung der Winkel β solange verändert, bis das Ausgangssignal U3 eine Nullspannung darstellt.

Es handelt sich hierbei, wie in den Figuren 3 und 3a dargestellt, um die Veränderung der Impulsbreite der Rechtecksteuersignale, die einander gegenläufig vorliegen, wobei entsprechend der Grobauflösung in ansich bekannter Weise die Impulsbreite, d.h. die Flanken 52,53 sozusagen schlagartig über die gesamte Impulshöhe hin verändert werden, wobei nachteilig eine ungenügende Auflösung in Kauf genommen werden muß.

Werden z.B. Rechtecksteuersignale mit einer Meßfrequenz von 8 KHz verwendet, die an den beiden Spulen am Eingang anliegt, so beträgt die minimale Impulsbreite der Rechtecksteuersignale 125 Nanosekunden.

Bei der Veränderung eines Inkrementes ändert sich die Breite des Impulses gemäss den Figuren 3 und 3a um eine bestimmte Breite $2 \cdot \beta$ ,wobei in bekannter Weise eine Auflösung von 2000 Schritten pro 2 mm vorliegt, was einer Auflösung von 1 Mikrometer entspricht.

Diese Schritte müssen auch elektronisch bei der Auswertung nachvollzogen werden, d.h. der Winkel α muß dem Wert β nachgeführt werden, wobei hier eine Verschiebung der Impulsflanken 52,53 je um den Wert β vorliegt. Insgesamt wird gemäss einer minimalen Auflösung, die bisher bekannt ist, die Impulsbreite um $2 \cdot \beta$ , das heisst 125 Nanosekunden, verändert gemäss einem einzigen Inkrementalschritt bei der relativen Verschiebung der verschiebbaren Teile nach Figur 1 zueinander. Diese Auflösung in Abhängigkeit von der verwendeten Meßfrequenz, die nicht ohne weiteres erhöht werden kann, ist jedoch relativ gering.

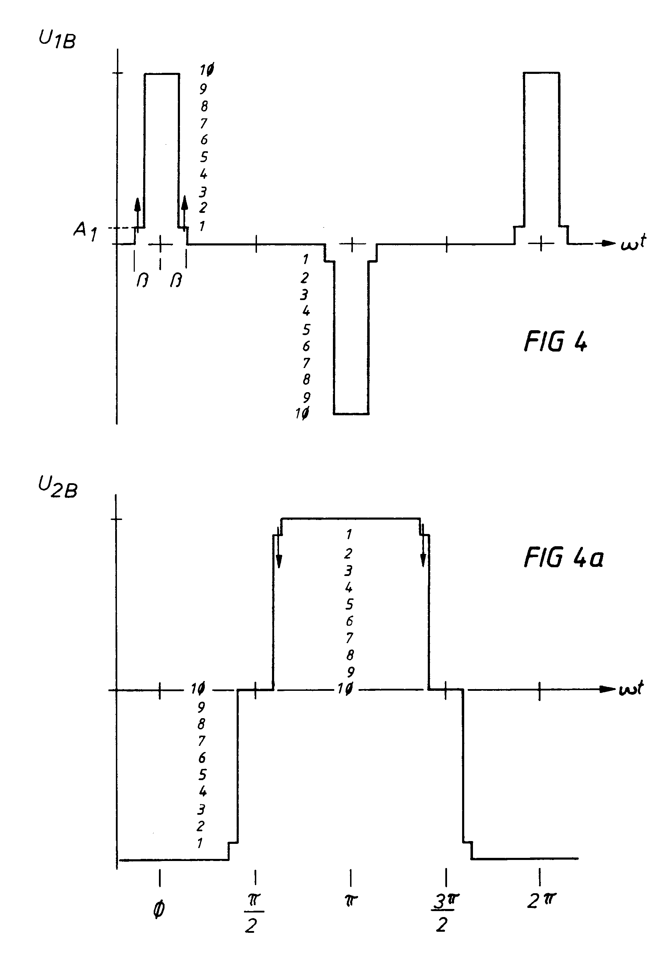

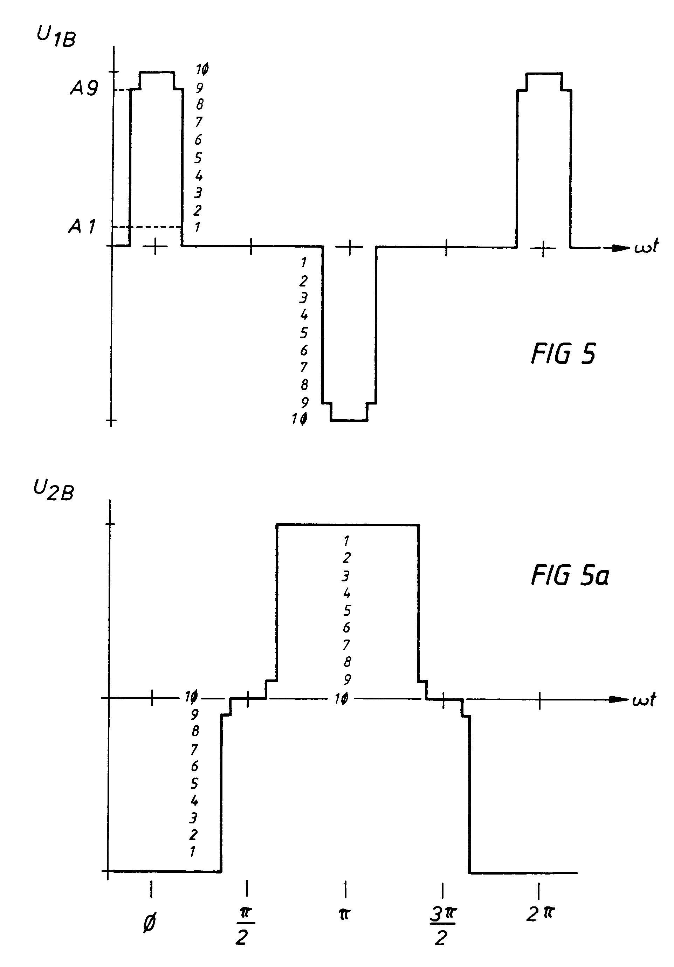

Die vorliegende Erfindung sieht nun bei gleicher Meßfrequenz eine erhöhte Auflösung nach Art einer Feinauflösung, beispielsweise um den Faktor 10, vor gemäss den Figuren 4 und 5 bzw. 4a und 5a, wo dargestellt ist, daß die Amplituden der Rechtecksteuersignale, bis der nächste Grobschritt erreicht ist, zunächst schrittweise erhöht bzw. verkleinert werden.

Wollte man bei bisherigen Anordnungen derart kleine Inkrementalschritte von 12,5 Nanosekunden verwenden, so wäre dies mit entsprechenden elektronischen Bausteinen nicht mehr oder nur mit hohem Aufwand zu verarbeiten, insbesondere weil die Impulsbreitenänderung infolge eines Inkrementalschrittes einer Frequenz von 80 MHz entspricht, was technisch nur schwierig zu beherrschen ist.

Bei dem vorliegenden Meßverfahren jedoch wird eine ansich gebräuchliche relativ niedrige Meßfrequenz und eine übliche Impulsbreitenänderung verwendet und trotzdem wird eine wesentlich höhere Auflösung nach Art einer zusätzlichen Feinauflösung erreicht.

Im wesentlichen wird dies dadurch erreicht, daß gemäss den Figuren 4 und 4a und den Figuren 5 und 5a die Impulsbreitenveränderung der bisherigen Grobeinstellung nicht schlagartig über die gesamte Höhe des Impulses erfolgt, sondern daß gemäss einer Feinauflösung zunächst die Amplitude der Rechtecksteuersignale schrittweise gemäss den eingezeichneten Pfeilen in den Figuren 4 und 4a aufgebaut bzw. abgebaut wird, bis nach Erreichen der vollen Amplitude der nächste Schritt der Grobauflösung erreicht ist.

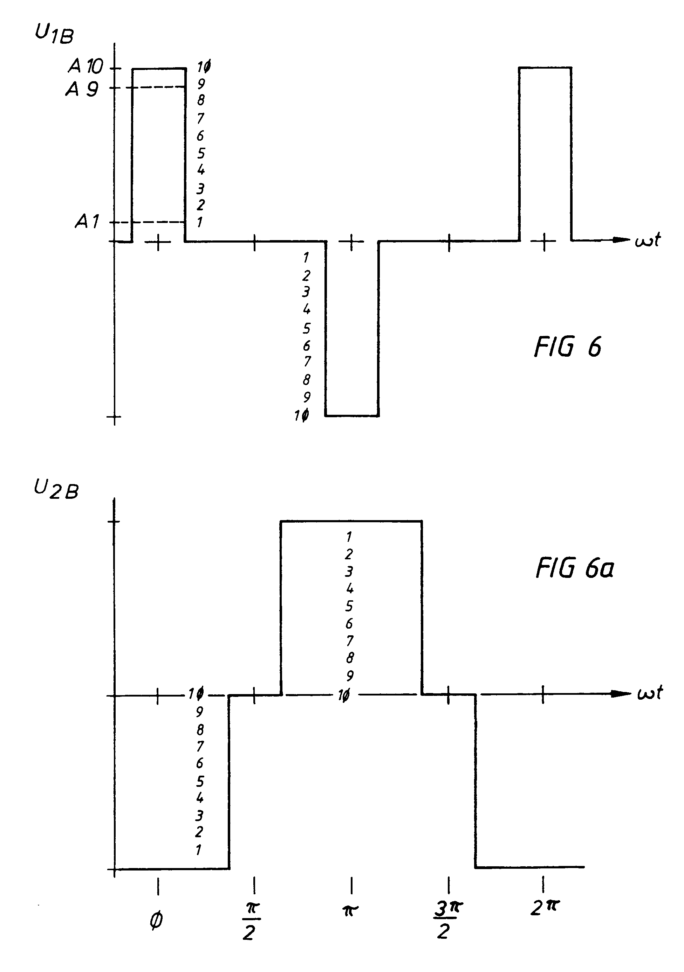

In den Figuren 4, 4a sowie in den Figuren 5 und 5a und den Figuren 6 und 6a ist dargestellt, daß ausgehend von einem Wert $\beta = 10$ nach den Figuren 3 und 3a zunächst bei den Figuren 4 und 4a eine Feinauflösung vorgenommen wird derart, daß die Amplitude gemäss einem Wert $\beta = 11$ um einen einzelnen Schritt gemäss einem Wert A1 erhöht wird.

Derart wird mit dem schrittweisen Aufbau bzw. Abbau der Amplitude in aufeinanderfolgenden Schritten nun eine Feinauflösung erreicht, wobei in den Figuren 5 und 5a ein Wert $\beta = 19$ dargestellt ist entsprechend einer Feinauflösung von neun Schritten mit einem Amplitudenwert A9.

In den Figuren 6 und 6a ist dargestellt, daß nach den aufeinanderfolgenden Schritten der Feineinstellung gemäss 10 Schritten dann der nächste Wert der Grobauflösung gemäss einem Wert $\beta = 20$ erreicht wird.

Die Figuren 3a, 4a sowie Figuren 5a, 6a entsprechen dem zweiten Kanal der Rechtecksteuersignale am Eingang der Meßeinrichtung, wobei diese Signale entgegengesetzt zu dem anderen Kanal am Eingang der Meßeinrichtung verlaufen gemäss den Figuren 3 - 6.

Aus den dargestellten Figuren 3 bis 6 wird demnach deutlich, daß zwar die Grobauflösung gemäss der inkrementalen Änderung der Impulsbreite in einzelnen Schritten beibehalten wird, daß aber zusätzlich eine Feinauflösung vorgenommen wird durch einen schrittweisen Aufbau bzw. Abbau der Amplitude der Rechteckeingangssignale, bis der nächste Schritt der Grobauflösung erreicht ist.

Vorteilhaft kann hierbei mit einer ansich bekannten vorteilhaften Meßfrequenz von etwa 8 KHz gearbeitet werden, wobei nun aber eine zehnfach gesteigerte Auflösung erhalten wird.

Die Figur 3 stellt demnach mit einem Zustand $\beta = 10$ eine gewisse Impulsbreite dar, die entsprechend der Figur 6 um einen weiteren Wert $\beta$ vergrößert wurde gemäss einer ansich bekannten Grobauflösung.

In Verbindung mit den Figuren 4 und 5 ist dargestellt, daß zwischen diesen Schritten der Grobauflösung die Feinauflösung durchgeführt wird gemäss der schrittweisen Vergrößerung bzw. Verkleinerung der Amplitude, wobei beispielsweise mit dem zehnten Schritt der Feinauflösung der nächste Schritt der Grobauflösung erreicht wird.

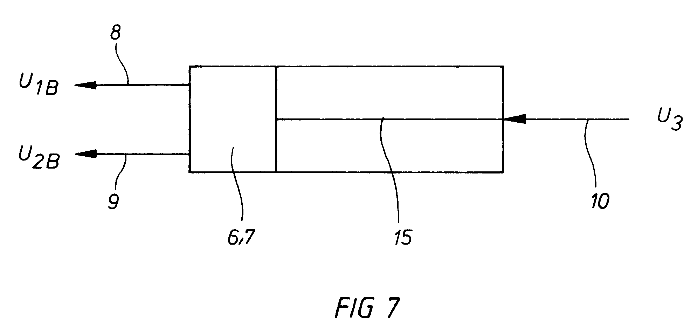

In Figur 7 ist die Steuerelektronik dargestellt, wo insbesondere ersichtlich wird, daß das Ausgangssignal U3 der Meßeinrichtung über eine Leitung 10 getrennten Stufen zugeführt wird entsprechend der ansich bekannten Impulsbreiten-Elektronik mit der Grobauflösung und der zusätzlichen Amplituden-Elektronik gemäss einer schrittweise vorgenommenen Feinauflösung. Über Ausgangsverstärker, insbesondere digitale Verstärker 6 und 7, erfolgt die Aufschaltung der Amplitude auf die Rechtecksteuersignale an den Leitungen 8 und 9 gemäss der vorgenommen Feineinstellung.

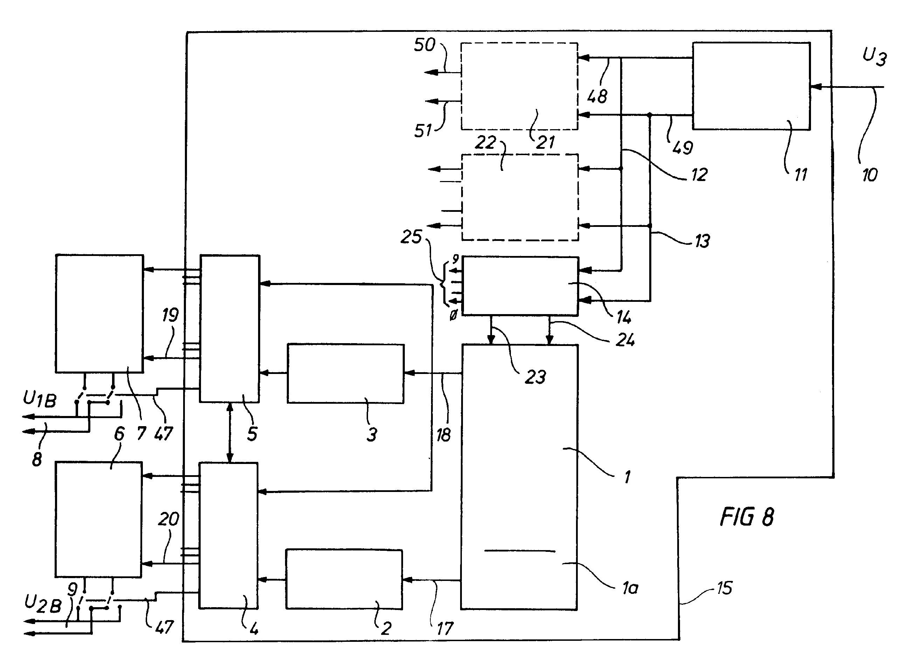

In Figur 8 ist ausgehend von dem Blockschaltbild nach Figur 7 die Steuerelektronik in einem verfeinerten Blockschaltbild dargestellt.

Aus Figur 8 wird ersichtlich, daß die Erhöhung der Auflösung ohne zeitliche Probleme etwa in Bezug auf eine höhere Meßfrequenz erreicht wird, lediglich durch einen zusätzlichen schrittweisen Aufbau der Amplitude im Bereich der nächstfolgenden Impulsbreite der Rechtecksteuersignale.

Aus Figur 8 wird ersichtlich, daß die Grobauflösung, z.B. 2000, in Bezug auf die übliche Impulsform und Impulsbreite nach Art einer Impulsbreiten-Modulation wie bisher vorgenommen wird.

Zusätzlich wird jedoch auch die Amplitude in der Steuerelektronik nach Figur 8 verarbeitet in Hinsicht auf die Realisierung der zusätzlichen Feinauflösung, z.B. um den Faktor 10, wobei die Impulsbreite der Rechtecksteuersignale zwar auf die Breite des nächsten Schrittes der Grobauflösung geändert wird, die Amplitude dieser zusätzlichen Impulsbreitenänderung ist aber zunächst reduziert und verändert sich mit den Schritten der Feinauflösung, bis nach beispielsweise 10 Schritten der Feinauflösung die Rechtecksteuersignale wieder denen der Grobauflösung entsprechen. Die Änderung der Impulsbreite und der Amplitude der Impulsbreitenänderung bei der Feinauflösung verändern sich bei umgekehrter Zählrichtung der Auflösungsschritte entgegengesetzt.

In spezieller konstruktiver Ausbildung ist nach Figur 8 eine digitale Ansteuer-Elektronik 1 vorgesehen, welche einen Oszillator 1a enthält, der z.B. mit einer Frequenz von 8 MHz schwingt.

Über die Ausgänge 17,18 wird diese Frequenz jeweils umlaufenden Zählern 2,3 zugeführt. Diese Zähler 2,3 arbeiten in ansich bekannter Weise nach bekannten Verfahren, und ergeben in Verbindung mit der Änderung der Impulsbreite die Grobauflösung.

Der Ausgang der Zähler 2,3 arbeitet jeweils auf eine Decodierstufe 4,5, wo die Impulsbreite in ansich bekannter Weise decodiert wird.

Ohne die zusätzliche Feinauflösung wären nun lediglich Ausgangsleitungen 19,20 dieser Decodierstufen 4,5 vorhanden, wo ein digitales Ausgangssignal entsprechend einem sonst bekannten Rechtecksteuersignal ansteht, dessen Impulsbreite der Grobauflösung entspricht.

Nach dem Stand der Technik werden dann die Ausgangssignale der Grobauflösung über die Leitungen 19,20 digitalen Verstärkern 6,7 eingespeist, wobei der Ausgang dieser Verstärker 6,7 über die Ausgangsleitungen 8,9 den Spulen nach Figur 1 entsprechend den Spannungen U1B und U2B eingespeist werden. Am Ausgang entsteht dann beim Stand der Technik das Ausgangssignal U3, das in ansich bekannter Weise entsprechend der Grobauflösung ausgewertet wird.

In zusätzlicher Anordnung, um eine Feinauflösung zu erreichen, sind jedoch nach Figur 8 zusätzliche Decodierungen und Austastungen, insbesondere zur Erzeugung von zusätzlichen Impulsen, vorgesehen und insbesondere zusätzliche Strom- oder Spannungsquellen, um die Amplituden der Rechtecksteuersignale an den Leitungen 8,9 zu erhöhen.

Es wird hier zunächst nach Figur 8 das Ausgangssignal U3 der Meßeinrichtung betrachtet, welches als Grundwelle des induzierten Signals der anfangs genannten Gleichung 3. entspricht und als Ausgangsspannung an der Meßeinrichtung 26 nach Figur 1 bzw. nach Durchlaufen eines Filters ansteht.

Dieses Ausgangssignal U3 der Meßeinrichtung wird über eine Eingangsleitung 10 einer Austaststufe 11 eingespeist. In dieser Austaststufe 11 werden mehrere Auswertungen vorgenommen. Zunächst wird durch Auswertung dieses Signals U3 erkannt, ob eine Verschiebung der beiden verschiebbar zueinander gelagerten Teile nach Figur 1 nach links oder rechts vorliegt, d.h. also die Zählrichtung 48. Weiterhin werden aufgrund des ansich bekannten Kompensationsprinzips oder Nachführrinzips in der Austastschaltung 11 solange Zählimpulse oder Wegimpulse 49 erzeugt, die im weiteren mit der Zählrichtung 48 der Ansteuerlogik 1 mitgeteilt werden, bis wieder an der Eingangsleitung 10 eine Spannung mit dem Wert Null ankommt, die aussagt, daß die Nachführung des elektrischen Winkels $\beta$ zum mechanischen Winkel $\alpha$ durchgeführt wurde.

Die Zählimpulse 49 und die Zählrichtung 48 werden entweder einer Auswerteschaltung 21 zugeführt, an deren Ausgang der zurückgelegte Weg zwischen den beiden verschiebbar zueinander gelagerten Teilen in inkrementaler Form von zwei um 90° elektrisch zueinander verschobenen digitalen Signalen ansteht, oder es kann in einer weiteren Auswertungsschaltung 22 der Absolutwert der Verschiebung gezählt und ausgegeben werden. Im weiteren werden sowohl die Zählimpulse oder Wegimpulse 49 und die Zählrichtung 48 der Austastschaltung 11 dem Zähler 14 zugeführt, der für die erfindungsgemässe Feinauflösung sorgt. In Verbindung mit dem Zähler 14 wird über die Decodierstufen 4,5 die Amplitude des an und für sich verbreiterten und wegeabhängig gebildeten Signals U1B, U2B schrittweise entsprechend der gewünschten Feinauflösung erhöht bzw. erniedrigt.

Die Werte des Zählers 14 resultieren in einer Ausgangsleitung 23, mit der die Zählrichtung des Zählers für die Feinauflösung der Ansteuerlogik 1 mitgeteilt wird und in einer Leitung 24, welche den Übertrag des Zählers 14 der Ansteuerlogik mitteilt, d.h. wenn um mehr als 10 Schritte gezählt wurde, um dann den nächsten Schritt der Grobauflösung anzuzeigen.

Wenn nun - hier nur als Beispiels dargestellt - 10 Schritte insgesamt gezählt wurden, erfolgt auf der Leitung 24 ein Übertragssignal, welches der Ansteuerlogik 1 mitgeteilt wird und über die Leitungen 17,18 werden die umlaufenden Zähler 2,3 der Grobauflösung mit genau einem Inkrementalschritt beaufschlagt.

Wesentlich ist nun, daß der Zähler 14, der von 0 bis 9 zählt, bzw. mit dem Übertragssignal beliebige Schritte zählen kann, diese Impulse von 0 bis 9 auf einer Zehndrahtleitung am Ausgang 25 den Decodierschaltungen 4 bis 5 mitteilt. In diesen Decodierschaltungen 4,5 ist nun eine zusätzliche Amplitudendecodierung vorgesehen, wo nun die Amplitude der Feinauflösung decodiert und mit der Impulsbreite verknüpft wird.

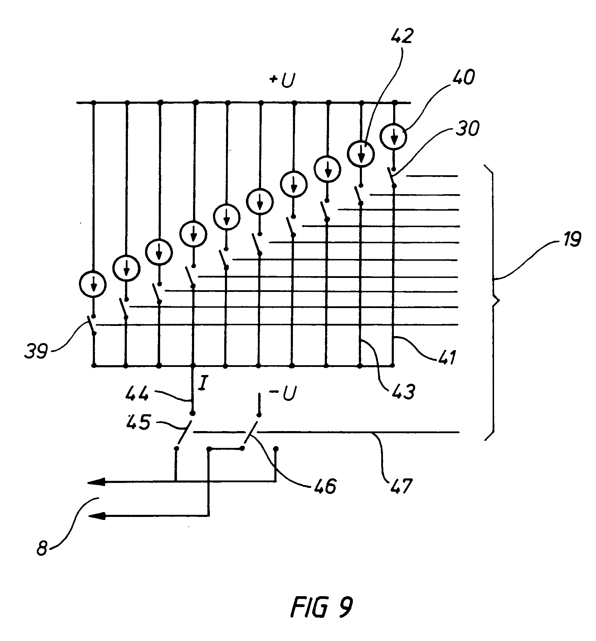

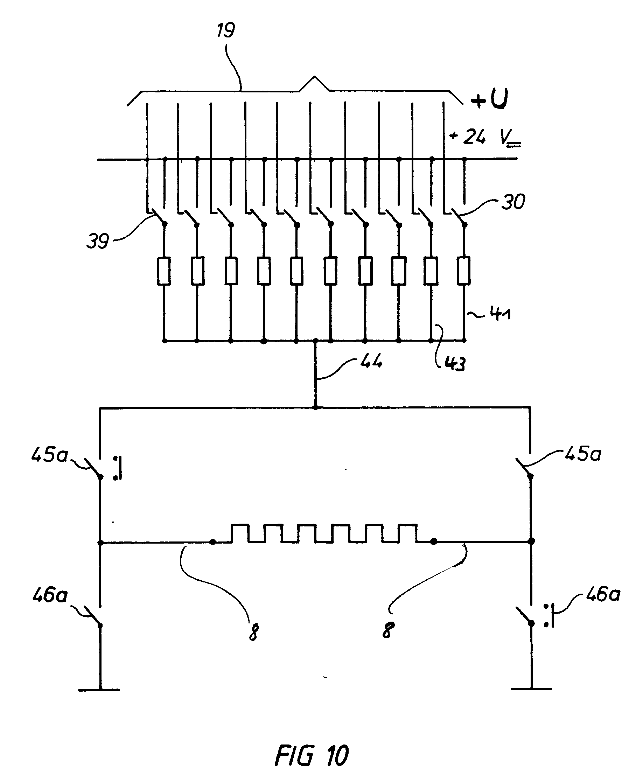

Die Verknüpfung der beiden Signale erfolgt in den nachgeschalteten digitalen Verstärkern 6,7 entsprechend einer Darstellung in Figur 9 oder einer weiteren Ausführung in Figur 10.

Der Ausgang der Decodierer 4,5 nach Figur 8 weist demnach 10 Signalleitungen auf, die nun nach den Figuren 9 und 10 Schaltern 30 - 39 zugeführt werden. Die Schalter 30 - 39 werden hierbei von Impulsen, die auf den Leitungen 19 liegen, in entsprechende Schließ- oder Öffnungsposition geschaltet.

Entsprechend der Stellung des jeweiligen Schalters 30 - 39 wird damit z.B. eine Stromquelle 40 mit einer Ausgangsleitung 41 verbunden und desgleichen wird entsprechend der Stellung eines zweiten Schalters eine Stromquelle 42 mit einer anderen Ausgangsleitung 43 verbunden und so weiter.

Die Stromquellen 40,42 arbeiten demnach auf eine gemeinsame Ausgangsleitung 44. Wegen der Notwendigkeit, für die Messeinrichtung sowohl positive als auch negative Impulse erzeugen zu müssen, sind entsprechende Umschalter 45,46 vorgesehen. Diese Schalter werden von einer Leitung 47 angesteuert, die ebenfalls einen Ausgang der Decodierschaltungen 4,5 bildet.

Hierdurch wird ein Rechtecksignal U1B bzw. U2B erzeugt, welches sowohl in positiver als auch in negativer Richtung verläuft entsprechend den Darstellungen nach den Figuren 3 bis Figur 6.

Ein anderes Ausführungsbeispiel für geschaltete Stromquellen, um die Amplituden zu bilden, ist in Figur 10 dargestellt. Dort sind gleiche Teile mit den gleichen Bezugszeichen versehen.

Hierbei werden wiederum nach Figur 10 die Schalter 30 - 39 durch die Leitungen 19 angesteuert und alle Signale werden über die Ausgangsleitung 44 über dazwischen angeordnete Schalter 45a, 46a, welche den Polaritätswechsel vornehmen, den Spulen gemäss Figur 1 mitgeteilt.

Die Schaltungen gemäss den Figuren 9 und 10 sind entsprechend den Eingangskanälen nach den Figuren 1 und 2 jeweils doppelt vorhanden, d.h. jeder Spule entsprechend den Spannungen U1B und U2B ist nach Figur 1 eine derartige Auswerteschaltung zugeordnet.

Ausgehend von dem Blockschaltbild nach Figur 8 ist ersichtlich, daß in Verbindung mit dem Zähler 14 zur Feinauflösung und der Ansteuerlogik 1 sowie der nachfolgenden Decodierung mit den Decodierstufen 4 und 5 je nach geforderter Genauigkeit der Feinauflösung die schrittweise Änderung der Amplitude im Bereich eines Schrittes der Grobauflösung linear vorgesehen sein kann oder ein bestimmter Algorithmus eingehalten wird.

Eine andere Gewichtung von Grob- und Feinauflösung im beschriebenen Meßverfahren ergibt hierbei verschiedene Formen der Steuersignale U1B und U2B. Die Änderung der Impulsbreite und der Amplitude folgen dann je einem eigenen Algorithmus oder einem gemeinsamen Algorithmus, der vom Zustand innerhalb des Bereichs der Grob- und Feinauflösung abhängen kann.

Das Meßverfahren erlaubt innerhalb des Bereichs der Grob- und Feinauflösung die Feststellung des absoluten Istwertes mit den Auswerteschaltungen 21,22, wobei die Istwertänderung auch inkremental ausgegeben wird. Große Meßbereiche werden hierbei in mehrere Teilbereiche mit Grob- und Feinauflösung unterteilt, wobei dann das Meßverfahren zyklisch absolut vorliegt.

Aus dem verfeinerten Blockschaltbild der Steuerelektronik gemäss Figur 8 sind insbesondere mehrere Blöcke ersichtlich, wobei in einem ersten Block das Ausgangssignal 10 der Meßeinrichtung aufbereitet und ausgewertet wird. Gewonnen werden hierbei die Zählrichtung 48 und die Wegimpulse 49. Die Frequenz der Wegimpulse 49 ist hierbei abhängig von der Amplitude des aufbereiteten Ausgangssignals U3 der Meßeinrichtung.

In einer weiteren Stufe können dann Wegimpulse 49 und die Zählrichtung 48 in zwei um 90° elektrisch phasenverschobene Signale 50,51 zur inkrementalen Ausgabe des zurückgelegten Weges aufbereitet werden. Mit einem entsprechenden Zählgerät erfolgt dann extern die Positionserfassung.

Zur Ausgabe des Absolutwertes der Position können die Zählrichtung 48 und die Wegimpulse 49 innerhalb der Steuerelektronik mit der Auswerteschaltung 22 mit einem Zähler erfasst werden.

Die Rechtecksteuersignale werden mit umlaufenden Zählern 2,3, angesteuert durch eine feste Oszillatorfrequenz 1a, gebildet. Abhängig von der Zählrichtung 48 und den Wegimpulsen 49 des Ausgangssignals U3 der Meßeinrichtung 26 nach Figur 1 werden zusätzliche Impulse zur festen Oszillatorfrequenz 1a in die umlaufenden Zähler 2,3 eingeschoben oder es werden Impulse der festen Oszillatorfrequenz unterdrückt. Hierdurch werden in Verbindung mit der entsprechenden Decodierung 4,5 die Impulsbreiten der Grobauflösung erzeugt. Die Information des Digitalwertes β liegt im Zustand der umlaufenden Zähler 2,3.

Zur Realisierung der zusätzlichen Feinauflösung werden die geschaffenen Wegimpulse 49 richtungsabhängig in einem zusätzlichen Zähler 14 für die Feinauflösung erfasst. Dieser Zähler zählt einzeln die jeweiligen Schritte der Feinauflösung. In der den umlaufenden Zählern 2,3 nachgeschalteten Decodierung 4,5 wird der Stand des Zählers 14 für die Feinauflösung berücksichtigt. In Bezug auf die Feinauflösung ist hierbei eine Erweiterung der Decodierung bezüglich der Amplitude geschaffen.

In der vorher beschriebenen Weise führen die Ausgänge 19,20 der Decodierung auf geschaltete Stromquellen 40,42 gemäss den Figuren 9 und 10, oder auf geschaltete Spannungsquellen, wo die endgültige Form der Rechtecksteuersignale mit der schrittweisen Erhöhung der Amplitude gebildet wird. Die Polarität bei Spannungsausgabe oder die Stromrichtung bei Stromausgabe wird durch Umpolen der Signalleitungen 8,9 der Rechtecksteuersignale U1B U2B erreicht.

Die Rechtecksteuersignale können hierbei als Strom- oder Spannungssignale erzeugt werden.

ZEICHNUNGS-LEGENDE

1a Oszillator (Ansteuerlogik)
2 Zähler
3 Zähler
4 Decodierstufe
5 "
6 digitaler Verstärker
7 "                    "
8 Ausgangsleitung
9 "
10 Eingangsleitung
11 Austaststufe
12 Ausgangsleitung
13 "
15 Auswerteelektronik
17 Ausgänge
18 "

19 Ausgangsleitung

20 "

21 Auswerteschaltung

22 "

23 Ausgangsleitung

24 Leitung

25 Ausgänge

26 Meßeinrichtung

30 Schalter

31 Schalter

40 Stromquelle

41 Ausgangsleitung

42 Stromquelle

43 Ausgangsleitung

44 "

45a Umschalter 45 Umschalter

46a Umschalter 46 Umschalter

47 Leitung

48 Zählrichtung

49 Wegimpulse

50 phasenverschobene Signale

51 "

52 Flanken

53 "

**Patentansprüche**

1. Meßverfahren zur Wegmessung mittels Resolver und Inductosyn bzw. Winkelmessung oder kontinuierliche Positionserfassung, wobei in Anwendung der Fourier-Analyse periodische Rechtecksignale U1, U2 den Eingangsspulen einer Meßeinrichtung zugeführt werden und am Ausgang der Meßeinrichtung durch Induktion in einer weiteren Spule ein Ausgangssignal U3 erzeugt wird und die Rechtecksignale U1, U2 am Eingang der Meßeinrichtung in der Impulsbreite einem Digitalwert $\beta$ folgen, wobei die Impulsbreiten der Rechtecksignale U1 bzw. U2 entsprechend einer Grobauflösung schrittweise mit dem Digitalwert $\beta$ verbreitert bzw. verkleinert werden und das Ausgangssignal U3 abhängig vom Wert entsprechend der mechanischen Position und abhängig vom Digitalwert durch Nachführen von Zählern auf Null abgeglichen wird und dann der bekannte Digitalwert $\beta$ der zu ermittelnden mechanischen Position entspricht und zusätzlich eine höhere Auflösung nach Art einer feinen Auflösung vorgesehen ist, derart, daß im Verlauf der Änderung der Impulsbreite der Rechtecksteuersignale U1 bzw. U2 auf die Breite des nächsten Schrittes der Grobauflösung zunächst schrittweise eine Änderung der Amplitude der Rechtecksteuersignale U1 bzw. U2 durchgeführt wird, **dadurch gekennzeichnet**, daß die Feinauflösung schrittweise linear und stetig durch Änderung der Amplitude A1 - A9 an den beiden Seiten der Rechtecksteuersignale U1, U2 im Bereich der jeweiligen Impulsbreite durchgeführt wird.

2. Meßverfahren nach Anspruch 1, **dadurch gekennzeichnet**, daß die Amplitudenänderung für die Feinauflösung in gleichen Schritten erfolgt.

3. Meßverfahren nach Anspruch 1, **dadurch gekennzeichnet**, daß die Amplitudenänderung für die Feinauflösung in sich stetig ändernden Schritten erfolgt.

4. Meßverfahren nach Anspruch 1, **dadurch gekennzeichnet**, daß die Grundwellen aus den Rechtecksteuersignalen vor der Meßeinrichtung (26) ausgefiltert werden.

5. Meßverfahren nach Anspruch 1, **dadurch gekennzeichnet**, daß die Rechtecksteuersignale $U_{1B}$, $U_{2B}$ direkt auf die Meßeinrichtung (26) geführt werden und die Grundwelle aus dem Ausgangssignal $U_3$ der Meßeinrichtung (26) ausgefiltert wird.

6. Meßverfahren nach Anspruch 1, **dadurch gekennzeichnet**, daß die Änderung der Impulsbreite und/oder der Amplitude gleichzeitig oder abwechslungsweise in den beiden Steuersignalen $U_{1B}$ und $U_{2B}$ erfolgen.

7. Meßverfahren nach Anspruch 1, **dadurch gekennzeichnet**, daß die Steuerelektronik der Meßeinrichtung (26) sowohl aus einer an sich bekannten Stufe für die Grobauflösung betreffend die Impulsbreiten als auch aus einer zusätzlichen Stufe (15) für die Amplitude betreffend die Feinauflösung besteht.

8. Meßverfahren nach Anspruch 1, **dadurch gekennzeichnet**, daß das Ausgangssignal $U_3$ der Meßeinrichtung (26) zunächst einer Austaststufe (11) zugeführt wird zur Erzeugung von Impulsen betreffend die Zählrichtung der Meßeinrichtung und zur Erzeugung von Wegimpulsen.

9. Meßverfahren nach Anspruch 1, **dadurch gekennzeichnet**, daß ausgehend von der Zählrichtung (48) und den Wegimpulsen (49) über eine zusätzliche Auswerteschaltung (21) zwei um 90° elektrisch verschobene Signale (50,51) erzeugt werden zur inkrementalen Ausgabe des zurückgelegten Weges zur externen Positionserfassung.

10. Meßverfahren nach Ansprüchen 1 - 9, **dadurch gekennzeichnet**, daß ausgehend von der Zählrichtung (48) und den Wegimpulsen (49) eine weitere Auswerteschaltung (22) vorgesehen ist zur Ausgabe des Absolutwertes der Position nach Art einer internen Positionserfassung.

11. Meßverfahren nach den Ansprüchen 1 - 10, **dadurch gekennzeichnet**, daß die Impulse betreffend die Zählrichtung (48) und die Wegimpulse (49) einem Zähler (14) zugeführt werden, der an seinem Ausgang (25) entsprechend den Schritten der Feinauflösung Ausgangsleitungen z.B. 0 bis 9 aufweist, die im weiteren der Decodierstufe (4,5) betreffend die Decodierung der Amplitude der Rechtecksteuersignale $U_{1B}$, $U_{2B}$ zugeführt werden.

12. Meßverfahren nach den Ansprüchen 1 - 11, **dadurch gekennzeichnet**, daß die Decodierstufen (4,5) am Ausgang mit digitalen Verstärkern (6,7) in Verbindung stehen, welche schrittweise entsprechend den Schritten der Feinauflösung über Strom oder Spannungsquellen (40,42) die Amplituden der Rechtecksteuersignale $U_{1B}$, $U_{2B}$ schalten.

13. Meßverfahren nach den Ansprüchen 1 - 12, **dadurch gekennzeichnet**, daß die Rechtecksteuersignale $U_{1B}$, $U_{2B}$ am Ausgang der digitalen Verstärker (6,7) über Umschalter (45,46) bzw. (45a, 46a) in der Polarität oder Stromrichtung umgeschaltet werden, wobei eine Steuerleitung (47) ausgehend von der Decodierstufe (4,5) mit den Umschaltern in Verbindung steht.

14. Meßverfahren nach Anspruch 1, **dadurch gekennzeichnet**, daß die Ansteuerlogik (1) mit dem Oszillator (1a) über eine Leitung (23) mit der Zählrichtung (48) des Ausgangssignals $U_3$ sowie über eine Leitung (24) mit dem Übertrag, ausgehend von dem Zähler (14) betreffend die Feinauflösung angesteuert wird, wobei über Ausgänge (17,18) mittels umlaufender Zähler (2,3) und Decodierstufen (4,5) in der Impulsbreite variable Signale betreffend einzelne Schritte der Grobauflösung gebildet werden.

15. Meßverfahren nach den Ansprüchen 1 - 14, **dadurch gekennzeichnet**, daß die Meßeinrichtung (26) auf induktiver Basis, z.B. Resolver und Inductosyn, eingesetzt wird.

16. Meßverfahren nach den Ansprüchen 1 - 14, **dadurch gekennzeichnet**, daß das Verfahren in optischen Meßeinrichtungen eingesetzt wird.

17. Meßverfahren nach den Ansprüchen 1 - 16, **dadurch gekennzeichnet**, daß im Zustand 0 der Grob- und Feinauflösung eine Nullmarke ausgegeben wird.

18. Meßverfahren nach den Ansprüchen 1- 17, **dadurch gekennzeichnet**, daß der Istwert innerhalb des Meßbereichs als Absolutwert oder inkremental ausgegeben wird.


## Claims

1. Measuring method for distance measurement by means of resolver and inductosyn or angle measurement or continuous position detection, wherein in application of Fourier analysis, periodic square wave signals U1, U2 are delivered to the input coils of a measuring device and an output signal U3 is generated at the output of the measuring device by induction in an additional coil and the square wave signals U1, U2 at the input of the measuring device follow a digital value β in pulse width, wherein the pulse widths of the square wave signals U1 and U2 are increased or decreased stepwise with the digital value β according to a coarse resolution and the output signal U3 is adjusted as a function of the value corresponding to the mechanical position and as a function of the digital value by resetting counters to zero and then the known digital value β corresponds to the mechanical position to be determined and in addition a higher resolution after the fashion of a free resolution is provided, such that in the course of variation of the pulse width of the square wave control signals U1 and U2 to the width of the next step of coarse resolution, first a change of amplitude of the square wave control signals U1 and U2 is carried out stepwise, characterised in that fine resolution is carried out stepwise linearly and constantly by changing the amplitude A1-A9 on both sides of the square wave control signals U1, U2 within the range of the respective pulse width.

2. Measuring method according to claim 1, characterised in that the amplitude change for fine resolution takes place in equal steps.

3. Measuring method according to claim 1, characterised in that the amplitude change for fine resolution takes place in constantly varying steps.

4. Measuring method according to claim 1, characterised in that the fundamental waves are filtered out of the square wave control signals before the measuring device (26).

5. Measuring method according to claim 1, characterised in that the square wave control signals $U_{1B}$, $U_{2B}$ are delivered directly to the measuring device (26) and the fundamental wave is filtered out of the output signal $U_3$ of the measuring device (26).

6. Measuring method according to claim 1, characterised in that the change of pulse width and/or amplitude takes place simultaneously or alternately in the two control signals $U_{1B}$ and $U_{2B}$.

7. Measuring method according to claim 1, characterised in that the control electronics of the measuring device (26) consist of both a circuit for coarse resolution relating to the pulse widths, which is known in the art, and an additional circuit (15) for the amplitude relating to fine resolution.

8. Measuring method according to claim 1, characterised in that the output signal $U_3$ of the measuring device (26) is first delivered to a blanking circuit (11) for the generation of pulses relating to the direction of counting of the measuring device and for the generation of distance pulses.

9. Measuring method according to claim 1, characterised in that starting from the direction of counting (48) and the distance pulses (49) via an additional analyser circuit (21) two signals (50, 51) electrically displaced by 90° are generated for incremental output of the distance covered for external detection of position.

10. Measuring method according to claims 1-9, characterised in that starting from the direction of counting (48) and the distance pulses (49), an additional analyser circuit (22) is provided for output of the absolute value of position after the manner of internal detection of position.

11. Measuring method according to claims 1-10, characterised in that the pulses relating to the direction of counting (48) and the distance pulses (49) are delivered to a counter (14) which comprises at its output (25), corresponding to the steps of fine resolution, output wires e.g. 0 to 9 which are subsequently connected to the decoding circuit (4, 5) relating to decoding of the amplitude of the square wave control signals $U_{1B}$, $U_{2B}$.

12. Measuring method according to claims 1-11, characterised in that the decoding circuits (4, 5) are connected at the output to digital amplifiers (6, 7) which switch the amplitudes of the square wave control signals $U_{1B}$, $U_{2B}$ stepwise according to the steps of fine resolution by means of current or voltage sources (40, 42).

13. Measuring method according to claims 1-12, characterised in that the square wave control signals $U_{1B}$, $U_{2B}$ are switched in polarity or direction of current at the output of the digital amplifiers (6, 7) by means of change-over switches (45, 46) or (45a, 46a), wherein a control wire (47) is connected to the change-over switches, starting from the decoding circuit (4, 5).

14. Measuring method according to claim 1, characterised in that the drive logic device (1) with the oscillator (1a) is driven via a wire (23) with the counting direction (48) of the output signal $U_3$ as well as via a wire (24) with the carry-over, starting from the counter (14) relating to fine resolution, wherein signals of variable pulse width relating to individual steps of coarse resolution are formed via outputs (17, 18) by means of rotary counters (2, 3) and decoding circuits (4, 5).

15. Measuring method according to claims 1-14, characterised in that the measuring device (26) is used on an inductive basis, e.g. resolver and inductosyn.

16. Measuring method according to claims 1-14, characterised in that the method is used in optical measuring devices.

17. Measuring method according to claims 1-16, characterised in that a zero mark is output in the 0 state of coarse and fine resolution.

18. Measuring method according to claims 1-17, characterised in that the actual value within the measuring range is output as an absolute value or incrementally.


## Revendications

1. Procédé de mesure pour la mesure de déplacement au moyen d'un résolveur et d'une graduation inductosyne ou pour la mesure d'angle ou la détection continue de position, dans lequel en utilisant l'analyse de Fourier, des signaux rectangulaires périodiques U1, U2 sont amenés aux bobines d'entrée d'un dispositif de mesure et à la sortie du dispositif, un signal de sortie U3 est produit par induction dans une autre bobine, les signaux rectangulaires U1, U2 amenés à l'entrée du dispositif de mesure suivant une valeur numérique β quant à la largeur de l'impulsion, les largeurs d'impulsion des signaux rectangulaires U1 ou U2 s'élargissant ou se réduisant de la valeur numérique β pas à pas de manière correspondant à une résolution grossière et le signal de sortie U3 étant égalisé en fonction de la valeur correspondant à la position mécanique et en fonction de la valeur numérique par remise des compteurs à zéro et la valeur numérique connue β correspondant alors à la position mécanique à déterminer et dans lequel il est prévu en outre une résolution supérieure à la manière d'une résolution libre de telle façon qu'au cours de la variation de la largeur d'impulsion des signaux rectangulaires de commande U1 ou U2 une modification de l'amplitude des signaux rectangulaires de commande U1 ou U2 soit d'abord effectuée pas à pas sur la largeur du pas suivant de la résolution grossière, caractérisé

EP 0 384 330 B1

en ce que la résolution fine est exécutée pas à pas linéairement et en permanence par la modification de l'amplitude de A1 à A9 des deux côtés des signaux rectangulaires de commande U1, U2 dans la zone de chaque largeur d'impulsion.

2. Procédé de mesure suivant la revendication 1, caractérisé en ce que la variation d'amplitude pour la résolution fine se fait suivant des pas égaux.

3. Procédé de mesure suivant la revendication 1, caractérisé en ce que la variation d'amplitude pour la résolution fine se fait suivant des pas qui varient constamment en eux-mêmes.

4. Procédé de mesure suivant la revendication 1, caractérisé en ce que les ondes fondamentales sont éliminées des signaux rectangulaires de commande avant le dispositif de mesure (26).

5. Procédé de mesure suivant la revendication 1, caractérisé en ce que les signaux rectangulaires de commande $U_{1B}$, $U_{2B}$ sont amenés directement au dispositif de mesure (26) et que les ondes fondamentales sont éliminées du signal de sortie $U_3$ du dispositif de mesure (26).

6. Procédé de mesure suivant la revendication 1, caractérisé en ce que la variation de la largeur d'impulsion et/ou de l'amplitude est effectuée simultanément ou alternativement dans les deux signaux de commande $U_{1B}$ et $U_{2B}$.

7. Procédé de mesure suivant la revendication 1, caractérisé en ce que l'électronique de commande du dispositif de mesure (26) se compose aussi bien d'un étage connu par lui-même pour la résolution grossière concernant les largeurs d'impulsion que d'un étage supplémentaire (15) pour l'amplitude concernant la résolution fine.

8. Procédé de mesure suivant la revendication 1, caractérisé en ce que le signal de sortie $U_3$ du dispositif de mesure (26) est d'abord amené à un étage de suppression (11) pour la production d'impulsions concernant le sens de comptage du dispositif de mesure et pour la production d'impulsions de déplacement.

9. Procédé de mesure suivant la revendication 1, caractérisé en ce que, à partir du sens de comptage (48) et des impulsions de déplacement (49) deux signaux (50, 51) déphasés électriquement de 90° sont produits par l'intermédiaire d'un circuit d'évaluation (21) supplémentaire pour la sortie incrémentielle du trajet parcouru jusqu'à la détection de position externe.

10. Procédé de mesure suivant les revendications 1 à 9, caractérisé en ce que, à partir du sens de comptage (48) et des impulsions de déplacement (49) un autre circuit d'évaluation (22) est prévu pour sortir la valeur absolue de la position à la manière d'une détection de position interne.

11. Procédé de mesure suivant les revendications 1 à 10, caractérisé en ce que les impulsions concernant le sens du comptage (48) et les impulsions de déplacement (49) sont amenées à un compteur (14) qui présente à sa sortie (25), en fonction des pas de la résolution fine, des lignes de sortie par exemple 0 à 9, qui sont amenées ensuite à l'étage décodeur (4, 5) concernant le décodage de l'amplitude des signaux rectangulaires de commande $U_{1B}$, $U_{2B}$.

12. Procédé de mesure suivant les revendications 1 à 11, caractérisé en ce que les étages décodeurs (4, 5) sont reliés à la sortie à des amplificateurs numériques (6, 7) qui commutent pas à pas en fonction des pas de la résolution fine les amplitudes des signaux rectangulaires $U_{1B}$, $U_{2B}$ par l'intermédiaire du courant ou des sources de tension (40, 42).

13. Procédé de mesure suivant les revendications 1 à 12, caractérisé en ce que les signaux rectangulaires de commande $U_{1B}$, $U_{2B}$ sont commutés, quant à la polarité ou au sens du courant à la sortie des amplificateurs numériques (6, 7) par l'intermédiaire de commutateurs (45, 46) ou (45a 46a), une ligne de commande (47) communiquant avec les commutateurs à partir de l'étage décodeur (4, 5).

14. Procédé de mesure suivant la revendication 1, caractérisé en ce que la logique de commande (1) avec l'oscillateur (1a) est commandée, par l'intermédiaire d'une ligne (23) par le sens de comptage (48) du signal de sortie $U_3$ ainsi que par l'intermédiaire d'une ligne (24) par la transmission, à partir du compteur (14) pour la résolution fine, des signaux variables quant à la largeur d'impulsion concernant des pas individuels de la résolution grossière étant alors produits par l'intermédiaire des sorties (17, 18) au moyen de compteurs rotatifs (2, 3) et d'étages décodeurs (4, 5).

15. Procédé de mesure suivant les revendications 1 à 14, caractérisé en ce que le dispositif de mesure (26) est mis en oeuvre sur une base inductive, par exemple par résolveur et graduation inductosyne.

16. Procédé de mesure suivant les revendications 1 à 14, caractérisé en ce que le procédé est mis en oeuvre dans des dispositifs de mesures optiques.

17. Procédé de mesure suivant les revendications 1 à 16, caractérisé en ce qu'une marque zéro est produite à l'état 0 des résolutions grossières et fines.

18. Procédé de mesure suivant les revendications 1 à 17, caractérisé en ce que la valeur effective est sortie dans le domaine de mesure en tant que valeur absolue ou de manière incrémentielle.

12

$U_3$

Scale (Rotor)

Slider (Stator)

26

$U_{1B}$ $U_{2B}$

*FIG 1*

$U_{1B}$

Filter

Inductosyn

$U_3$

8 9

Filter

Resolver

10

$U_{2B}$

26

*FIG 2*

$U_{1B}$

$\beta$ $\beta$    $\beta$ $\beta$    $\beta$ $\beta$

53    52

$\omega t$

FIG 3

$U_{2B}$

$\beta$ $\beta$    $\beta$ $\beta$

FIG 3a

53    52

$\omega t$

$\emptyset$    $\dfrac{\pi}{2}$    $\pi$    $\dfrac{3\pi}{2}$    $2\pi$

EP 0 384 330 B1

FIG 4

FIG 4a

15

FIG 5

FIG 5a

FIG 6

FIG 6a

EP 0 384 330 B1

$U_{1B}$ ←

8

$U_{2B}$ ←

9

$U_3$ ←

10

6,7

15

*FIG 7*

FIG 8

EP 0 384 330 B1

FIG 9

FIG 10